# EUROPEAN PATENT APPLICATION

(11) **EP 3 279 674 A1**
(43) Date of publication of application: **07.02.2018**
(21) Application number: 17175952.5
(22) Date of filing: 14.06.2017
(51) Int. Cl.: G01R 22/06

(54) **METERING SYSTEM TAMPER DETECTION**

(30) Priority: 05.08.2016 US 201615229620
(71) Applicant: Honeywell International Inc., Morris Plains, NJ 07950 (US)
(72) Inventor: PAMBUCOL, Vlad, Morris Plains, NJ 07950 (US); HOLT, John Richard, Morris Plains, NJ 07950 (US); LOBASTOV, Konstantin, Morris Plains, NJ 07950 (US); COOPER, David, Morris Plains, NJ 07950 (US); HOLDSCLAW, Scott, Morris Plains, NJ 07950 (US)
(74) Representative: Houghton, Mark Phillip

(57) **Abstract**

A metering system for metering consumption of a commodity. The metering system comprising a meter socket and a meter. The meter comprising a memory, a plurality of sensors, and a processor. Each of the plurality of sensors is configured to detect a different condition of the meter. The processor is configured to determine a plurality of events that have occurred based on the conditions detected by the sensors; compare the plurality of events to a table stored in the memory of the meter, the table defining an action to be performed by the meter for each of a plurality of different combinations of the plurality of events; select an action from the table for which the plurality of events match a corresponding combination of events stored in the table; and perform the selected action.

## Description

### TECHNICAL FIELD

The present invention relates to a metering system and method, and more particularly, to systems and methods for detecting abnormal conditions in a metering device.

### BACKGROUND

Metering systems are subject to tamper events. Tamper events may include anything from bypassing a disconnect switch within a meter to interchanging meters from one consumer location to another. Because metering systems can be tampered with in many ways, there are many ways in which a meter can react. Current metering systems have a variety of tamper detection methods available; however, generally a single tamper sensor results in a single meter response.

The foregoing background discussion is intended solely to aid the reader. It is not intended to limit the innovations described herein. Thus, the foregoing discussion should not be taken to indicate that any particular element of a prior system is unsuitable for use with the innovations described herein, nor is it intended to indicate that any element is essential in implementing the innovations described herein. The implementations and application of the innovations described herein are defined by the appended claims.

### SUMMARY

An improved metering system for determining whether a tamper condition is present in a metering device is desired to more effectively determine what corrective actions to carry out.

An aspect of the present disclosure provides a metering system comprising a meter socket and a meter. The meter is configured to couple to the meter socket. The meter comprises a memory, a plurality of sensors, and a processor. Each of the plurality of sensors are configured to detect a different condition of the meter. The processor is configured to: determine a plurality of events that have occurred based on the conditions detected by the sensors; compare the plurality of events to a table stored in the memory of the meter, the table defining an action to be performed by the meter for each of a plurality of different combinations of the plurality of events; select an action from the table for which the plurality of events match a corresponding combination of events stored in the table; and perform the selected action.

Another aspect of the present disclosure provides a method for controlling a meter. The meter and a meter socket composing a metering system. The method comprising: detecting a plurality of different conditions of the meter; determining a plurality of events that have occurred based on the detected plurality of different conditions; comparing the plurality of events to a table stored in a memory of the meter, the table defining an action to be performed by the meter for each of different combinations of the plurality of events; selecting an action from the table for which the plurality of events match a corresponding combination of events stored in the table; and performing the selected action.

Another aspect of the present disclosure provides a meter comprising a memory, a plurality of sensors, and a processor. Each of the plurality of sensors is configured to detect a different condition of the meter. The processor is configured to: determine a plurality of events that have occurred based on the conditions detected by the sensors; compare the plurality of events to a table stored in the memory of the meter, the table defining an action to be performed by the meter for each of a plurality of different combinations of the plurality of events; select an action from the table for which the plurality of events match a corresponding combination of events stored in the table; and perform the selected action.

This summary is provided to introduce a selection of concepts in a simplified form that are further described below in the Description of the Invention section. This Summary is not intended to identify key features or essential features of the claimed subject matter, nor is it intended to be used to limit the scope of the claimed subject matter. Furthermore, the claimed subject matter is not constrained to limitations that solve any or all disadvantages noted in any part of this disclosure.

### BRIEF DESCRIPTION OF THE DRAWINGS

A more detailed understanding may be had from the following description, given by way of example in conjunction with the accompanying drawings, wherein:
FIG. 1 illustrates a metering system in which the systems, methods, and apparatus disclosed herein may be embodied.
FIG. 2 illustrates a schematic of the metering system of FIG. 1, according to an aspect of the disclosure.
FIG. 3 illustrates a schematic of a controller, according to an aspect of the disclosure.
FIG. 4 illustrates a flow diagram for monitoring metering operations within a metering system, according to an aspect of the disclosure.
FIG. 5 illustrates a table of example scenarios for meter responses, according to an aspect of this disclosure.

### DESCRIPTION OF THE INVENTION

The disclosure relates generally to metering systems and methods for monitoring consumption of a commodity, such as electricity. Although the system and methods are described herein in the context of a system for metering electrical energy consumption, it is understood that the system and methods described herein may be implemented in systems that monitor consumption of other commodities, such as, for example, water or gas. In one embodiment, the metering system includes a meter and a meter socket located at a customer location. The metering system includes a means for obtaining information from the meter and meter socket. This could be a physical connection such as a cable between the meter and device in the socket, a wireless RF connection, or other means. In this description, the meter includes at least one sensor, and the meter socket includes an information storage device comprising identification information. As used herein, the term "information storage device" will be understood to include a means to store identification information in the meter socket and a means to communicate that information to the meter as described in further detail below. When the meter is coupled to the meter socket, at least one sensor may obtain information from the metering system, such as the identification information from the information storage device, a movement of the meter, a magnetic field, a power interruption, a reverse energy, an excessive number of security access failures, a current transformer saturation, or still other meter information. Based on the information obtained from the at least one sensor, the metering system may determine an appropriate response or action.

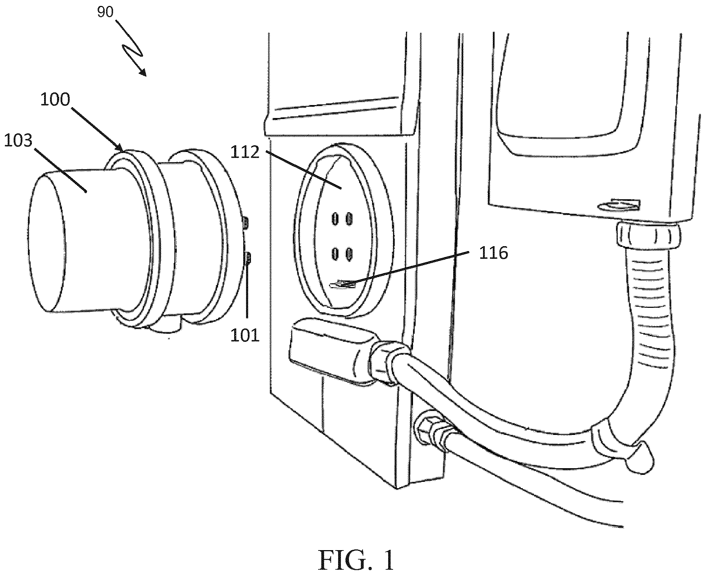

FIG. 1 provides a perspective view of a metering system 90 having a meter 100 and a meter socket 112 that may be installed at a utility customer location. The meter socket 112 may, in turn, be connected to one or more electrical loads at the customer location. In one embodiment, the meter socket 112 is configured to receive and electrically connect with blades 101 of the meter 100. Meter 100 may include a meter cover 103 and may be any type of meter configured to measure and indicate the amount of energy consumption at a customer location, such as a residence, industry or business.

Meter 100 may be part of a metering network in which the methods, systems, and apparatus disclosed herein may be employed. The metering network may comprise a plurality of meters 100, which are operable to sense and record consumption or usage of a service or commodity. Meters 100 may be located at customer premises, such as a home or place of business. Meters 100 comprise circuitry for measuring the consumption of the service or commodity being consumed at their respective locations and for generating data reflecting the consumption, as well as other data related thereto. Meters 100 may also comprise circuitry for wirelessly transmitting data generated by the meter to a remote location. Meters 100 may further comprise circuitry for receiving data, commands or instructions wirelessly as well. Meters that are operable to both receive and transmit data may be referred to as "two-way" meters, while meters that are only capable of transmitting data may be referred to as "transmit-only" or "one-way" meters. In bi-directional meters, the circuitry for transmitting and receiving may comprise a transceiver.

The meter socket 112 may further comprise an information storage device or tag 116. The tag 116 may be attached to any part of the meter socket 112 with adhesive glue, double-sided or single-sided tape, soldering, or other similar adhesive commonly used by those skilled in the art.

The tag 116 may be a radio frequency identification (RFID) tag, such as a near field communication (NFC) tag. The tag 116 may contain electronically stored identification information that is unique to tag 116 and may be identified by using radio waves at, for example, a 13.56 MHz frequency. The tag 116 may contain an induction coil (not shown), that through excitation generated by a variable electromagnetic field generated by a reader, powers a small circuit (not shown) that is read by the reader through RF waves. In one embodiment, the tag 116 comprises an NFC tag, which is a subset of RFID tags. In one embodiment, the tag 116 is a passive device. In other embodiments, the tag 116 may be an active device.

In an aspect, every meter socket 112 within a metering network may be equipped with a tag 116 that includes identification information that uniquely identifies that meter socket. The identification information may include, for example, a geographic location of the meter socket 112. Each tag 116 may be supplied in bulk, supplied with every meter 100, or pre-installed in the meter socket 112. For example, the tag 116 may be taped onto a cover of the meter 100 using a peel-off sticker. When a meter technician installs the meter 100 with the socket 112, the tag 116 may be peeled off and coupled to the socket 112. Each tag 116 may be pre-encoded or may be encoded by a technician installing the tag 116.

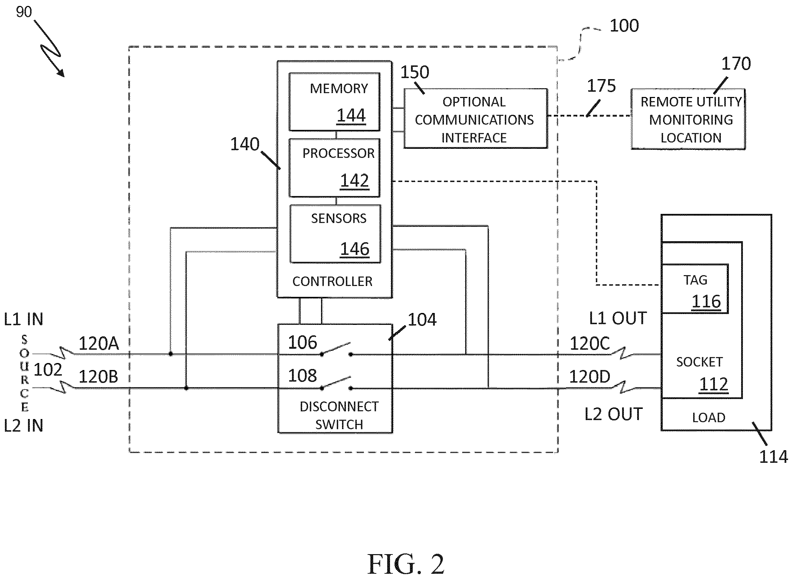

FIG. 2 illustrates an embodiment of a meter 100, according to an aspect of this disclosure. The meter 100 is interposed into electricity distribution lines 120, and the meter 100 is disposed between an electrical energy source 102 and an electrical load(s) 114 at a utility customer location. In the embodiment shown, the meter 100 meters electrical energy delivered from the source 102 to the load 114 via distribution lines 120. In particular, the meter 100 connects to a source-side of the distribution lines at contacts 120A and 120B and to a load-side at contacts 120C and 120D. The meter 100 measures the consumption of electrical energy by the load 114.

As further shown, the meter 100 comprises a disconnect switch 104, a controller 140, and an optional communications interface 150. The meter 100 may further comprise other components commonly used in metering devices. This description is specific to a single phase meter, but the principles are also applicable to polyphase electricity meters as well.

The disconnect switch 104 is interposed into the distribution lines 120 and is configured to switch between an open position, in which electrical energy is not supplied to the electrical load 114, and a closed position, in which electrical energy is supplied to the electrical load 114. Electrical energy (at meter inputs "L1 IN" and "L2 IN") is supplied by the source 102 and delivered, via source side distribution lines 120A and 120B, through meter 100, to the electrical load at the customer location 114 (via meter outputs "L1 OUT" and "L2 OUT"). Disconnect switch or electrical relay 104 is interposed into the distribution lines 120, effectively separating the distribution lines into source side distribution lines 120A and 120B, and load-side distribution lines 120C and 120D. As shown, in this embodiment, the disconnect switch or relay 104 comprises two switches 106, 108 - one for each distribution line. When disconnect switch 104 is closed, electrical energy should be supplied to customer location 114, and when disconnect switch 104 is open, no electrical energy should be supplied to customer location 114. The switches 106, 108 may be driven by a motor, a solenoid, or other means commonly used to drive a disconnect switch.

The optional communications interface 150 may be configured to communicate with the controller 140 and a remote utility monitoring location 170. The optional communications interface 150 may be a two-way communications interface to the remote utility monitoring location 170 (e.g. head-end system) and may comprise any suitable communications interface technology, such as a radio frequency (RF) transceiver, or an interface to the telephone lines or power lines at the customer location 114, etc. The optional communication interface 150 may communicate with remote utility monitoring location 170 via communications link 175. Communications link 175 may be a private or public network, such as a subnet/LAN.

The controller 140 may be configured to record data reflecting energy consumption measured by the meter 100 and to control various internal functions of the meter 100. The controller 140 may be an electronic control unit, computing device, central processing unit, or other data manipulation device that may be used to facilitate control and coordination of any of the methods or procedures described herein.

In one embodiment, the controller 140 comprises a processor 142, such as a microprocessor, microcontroller, or the like, a memory 144, and sensors 146. The processor 142 may be operatively coupled to the sensors 146, the disconnect switch 104, the memory 144, and the optional communications interface 150. The processor 142 may be configured to receive signals from the sensors 146, the disconnect switch 104, the memory 144, and the optional communications interface 150, to process the signals, and to store the signals in memory 144.

The utility monitoring station 170 may send and receive commands to and from the meter 100 via communications link 175. In response to a command, the controller 140 may operate the meter 100 by, for example, operating the disconnect switch 104 to open or close position, reading measured current or voltage information within the distribution lines 120, or performing other metering operations. Information received by the controller 140 from the utility monitoring station 170, sensors 146, or other metering components may be stored in memory 144. Information received by the controller 140 may also be provided to the remote utility monitoring location 170 to be stored remotely.

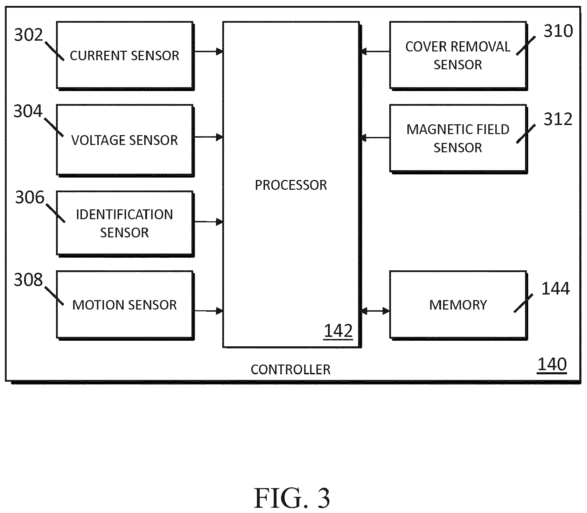

FIG. 3 illustrates a block diagram of an embodiment of the components that may comprise the controller 140. Sensors 146 may include a current sensor 302, a voltage sensor, 304, an identification sensor 306, a motion sensor 308, a cover removal sensor 310, a magnetic sensor 312, or still other sensors. While the controller 140 is represented as a single unit, in other aspects the controller 140 may be distributed as a plurality of distinct but interoperating units, incorporated into another component, or located at different locations on or off the meter 100.

The current sensor 302 and the voltage sensor 304 are configured to measure current flow and voltage, respectively, at contacts 120A and 120B on the source-side of the distribution lines 120. In alternative aspects, the current sensor 302 and the voltage sensor 304 may be further configured to measure current and voltage, respectively, at contacts 120C and 120D on the load-side of the distribution lines 120. The current sensor 302 and the voltage sensor 304 may provide signals to the processor 142 indicative of the current flow and voltage, respectively.

The identification sensor 306, also referred to as a reader, may be coupled to the processor 142. The identification sensor 306 is configured to obtain (e.g., read) the identification information from the tag 116 and provide a signal indicative of the identification information to the processor 142. The sensor 306 may be an RFID reader and/or a NFC reader.

The motion sensor 308 may be coupled to the processor 142 and configured to sense a motion of the meter 100. For example, the motion sensor 308 may be configured to sense a tilt or vibration of the meter 100 relative to the meter socket 112 due to, for instance, removal of the meter 100 from the socket 112 or an external force applied to the meter 100. The motion sensor 308 may provide a signal indicative of the motion to the processor 142.

The cover removal sensor 310 and the magnetic field sensor 312 may be coupled to the processor 142 and configured to sense whether the meter cover 103 has been removed from the meter 100 and whether a magnetic field exists at the meter 100 location, respectively.

Sensors 146 may further include devices capable of sensing reverse energy, detecting excessive security access failures, power interruption, detecting current transformer saturation, or still other metering parameters.

In accordance with an aspect of the system and method described herein, during installation of meter 100 into the meter socket 112 at a given customer location, the meter 100 may be paired with identification information of the tag 116 of the meter socket 112. In one embodiment, a technician may use an installation tool (not shown) equipped with a tag reader to read the tag 116 of the meter socket and then 112 to input the identification information to the meter 100. In other embodiments, the sensor 302 of the meter 100 may automatically read the identification information from the tag 116 upon insertion of the meter 100 into the socket 112 during initial installation. The meter 100 may then store information indicative of its pairing with the identification information for the socket 112. In this respect, the stored identification information obtained from the tag 116 of the meter becomes the "expected" identification information for that meter. This pairing of the meter 100 with the identification information of the tag 116 may also be recorded by the technician using the installation tool, or the pairing may be reported by the meter 100 to the remote utility monitoring location 170 via the communication interface 150.

Thereafter, in operation, upon power up of the meter 100, the sensor 302 may read the tag 116 attached to the meter socket 112 to obtain its identification information and may compare the identification information read from the tag 116 to the "expected" identification information recorded during the initial meter pairing.

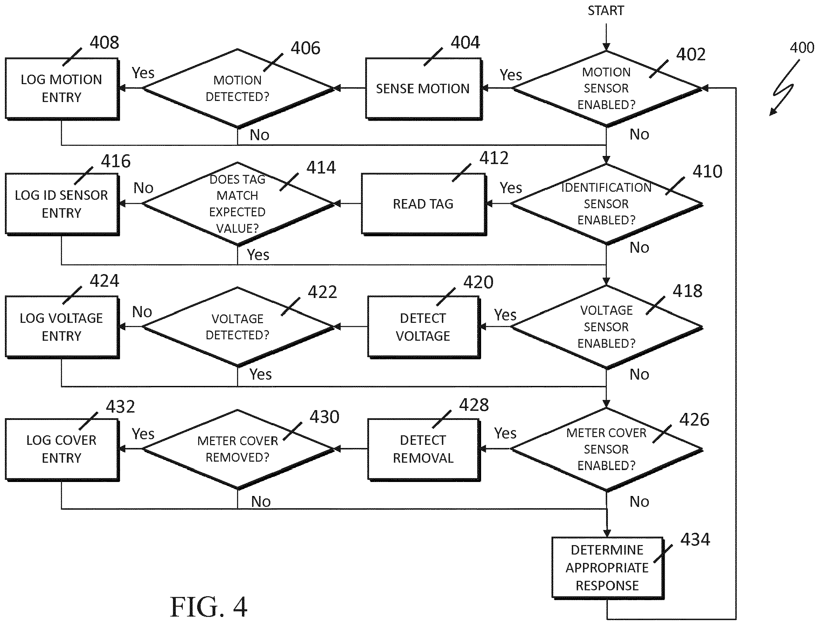

FIG. 4 illustrates a method 400 for determining a meter response based on conditions of the meter 100 (e.g. a tamper event), according to an aspect of this disclosure. The method 400 may begin by power cycling the meter 100 (*e.g.,* power up after a power down). At step 402, the meter 100 determines whether the motion sensor 308 is enabled. If the motion sensor 308 is enabled, then at step 404, a condition of the meter 100 is sensed, for example, a motion of the meter 100, by the motion sensor 308. The condition of the meter 100 may be stored in memory 144. At step 406, the processor 142 determines whether a motion of the meter 100 has been detected. Determining whether motion has been detected may include a motion test. The motion test may include, for example, sensing a frequency of the motion (e.g. 4 movements/tilts) of the meter 100 over a certain time period (e.g. 2 minutes). If 4 movements/tilts of the meter 100 are sensed within the 2 minute time period, the meter 100 fails the motion test, indicating that motion of the meter 100 has been detected. At step 408, if motion has been detected, the processor 142 may log this in memory 144 as a 'fail' event and may send an alert to the remote utility monitoring location 170. Conversely, if motion of the meter 100 has not been detected, the processor 142 may log this in memory 122 as a 'pass' event.

If the motion sensor 308 has not been enabled, or after motion detection has occurred, then at step 410, the meter 100 determines whether the identification sensor 306 is enabled. If the identification sensor 306 is enabled, then at step 412, the identification information is read from tag 116 by the identification sensor 306. The identification sensor 306 provides a signal to the processor 142 indicative of the identification information. The processor 142 may store the identification information from the tag 116 in memory 144. At step 414, the processor 142 compares the signal indicative of the identification information read from the tag 116 with the expected tag 116 identification information stored during the initial pairing of the meter 100 with the socket 112. At step 416, if the signal indicative of the identification information read from the tag 116 of the meter socket 112 does not match the expected identification information recorded during the pairing process, or the identification sensor 306 fails to read the tag 116 of the meter socket 112, then the processor 142 may log this condition as a 'fail' event in memory 144 and may send an alert to the remote utility monitoring location 170. Conversely, if the identification information read from the tag 116 does match the expected identification information recorded during the pairing process, the processor 142 may log this condition as a 'pass' event in memory 144.

If the identification sensor 306 has not been enabled, or after identification detection has occurred, then at step 418, the meter 100 determines whether the voltage sensor 304 is enabled. If the voltage sensor 304 is enabled, then at step 420, a condition (e.g. a source-side voltage or a load-side voltage) at the meter 100 is detected by the voltage sensor 304 and stored in memory 144. At step 422, the processor 142 determines whether a voltage of the meter 100 has been detected. Determining whether voltage has been detected may include a power fail test. The power fail test may include, for example, sensing a source-side voltage of the meter 100 over a certain time period (e.g. 2 minutes). If there is no source-side voltage sensed for more than the 2 minute time period, the meter 100 fails the power fail test, indicating that voltage has not been detected at the meter 100. At step 424, if voltage has not been detected, the processor 142 may log this event in memory 144 and may send an alert to the remote utility monitoring location 170.

If the voltage sensor 304 has not been enabled, or after voltage detection has occurred, then at step 426, the meter 100 determines whether the cover removal sensor 310 is enabled. If the cover removal sensor 310 is enabled, then at step 428, the cover removal sensor 310 senses a condition (e.g. whether the meter cover 103 has been removed from the meter 100) and stores an indication of whether the cover 113 has been removed from the meter 100 in memory 144. If the processor 142 determines the cover 113 has been removed (430) from the meter, at step 432, the processor 142 may log this event in memory 144 and may send an alert to the remote utility monitoring location 170.

The method 400 only illustrates one example of detecting an abnormal condition. Fewer sensors 146 may be used, or more sensors 146 may be used, for example, the magnetic field sensor 312. Additionally, the order in which the sensors are checked to determine whether they are enabled may vary. For example, the status of the cover removal sensor 310 may be checked prior to the status of the motion sensor 308.

If the magnetic field sensor 312 is enabled, the magnetic field sensor 312 may sense a condition (e.g. a magnetic field) at the meter 100. The processor 142 may determine whether a magnetic field has been detected using a magnetic field test. The magnetic field test may include, for example, a magnetic field sensor threshold (e.g. 1.2 Volts) and a time duration that the magnetic field sensor's output is above the threshold (e.g. 10 seconds). If the sensed magnetic field sensor's output is above 1.2 Volts for more than 10 seconds, the meter 100 fails the magnetic field test. An indication of this failure event may also be used in determining whether an appropriate response of the meter 100.

Each of the sensors 146 may be configured to provide a set of inputs to the processor 142. For example, the following indicators for the conditions detected by the sensors 146 may be provided to the processor 142 during the method 400: an indication of whether the sensor 146 is enabled, whether a threshold has been exceeded, a frequency with which the threshold has been exceeded, and the time duration the threshold has been exceeded. Each of the indicators provided to the processor 142 may be used to determine whether each test (e.g. motion test, power fail test, identification test, cover removal test, and magnetic field test) has failed or passed. The result of each test or the status of the particular sensor 146 (e.g. pass, fail, or not enabled) may be stored in memory 144 as an event.

Based on each of the indicators for the conditions sensed by the sensors 146 logged in memory 144, at step 434, the meter 100 may determine an appropriate response. For example, the meter may respond by recording billing information to an alternate register, taking a billing snapshot, logging the abnormal condition in memory 144, disabling the optional communications module 150, controlling the disconnect switch 104 to the open position, sending alarms to the remote utility monitoring location 170, or still other responses.

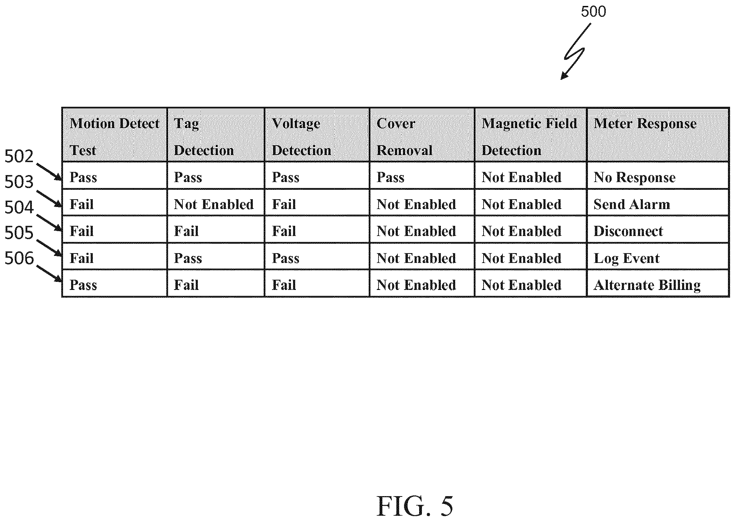

FIG. 5 illustrates a table 500 stored in the memory 144 of the meter 100 in accordance with one embodiment. As shown, the table comprises a plurality of entries 502, 503, 504, 505, and 506, each of which defines an action to be performed. For example, for a particular combination of detected events, the detected events are compared to the events stored in table 500, and an action is selected for the meter 100 to perform based on how the detected events align with the stored events. Table 500 is merely exemplary and only shows an example of five different combinations of events stored in memory 144 and their corresponding meter 100 responses.

Each sensor 146 may either be enabled or not enabled. If the sensor 146 is enabled, then the processor 142 may determine whether the test corresponding to the particular sensor 146 has passed or failed. For example, the first entry 502 of the table 500 illustrates a first plurality of events that indicate that the motion detect test, tag detection, voltage detection, and cover removal tests have all been enabled and have all passed. The magnetic field test has not been enabled, and therefore, has neither passed nor failed. Based on the results of each enabled test, the first entry 502 indicates that the meter 100 has no response and continues to monitor consumption. The second entry 503 of the table 500 illustrates a second plurality of events that indicates that the motion detect test and the voltage detection have been enabled and have both failed. The tag detection, cover removal, and magnetic field detection tests have not been enabled, and therefore, have neither passed nor failed. Based on the results of each enabled test, the second entry 503 indicates that the meter 100 response is to send an alarm to the remote utility monitoring location 170. The remaining entries 504 through 506 in table 500 each illustrate additional examples of various events of test results and corresponding meter responses.

It will be appreciated that the list of scenarios 502 through 506 is merely demonstrative, and more scenarios and corresponding responses may be contemplated and stored in memory 144. Further, additional or fewer tests may be incorporated into each scenario in order to determine the appropriate meter 100 response.

It will be appreciated that the method 400 may be repeated at a desired frequency. For example, the method 400 may repeat after every power cycle of the meter 100, or the method 400 may repeat on an hourly, daily, or weekly basis.

While the disclosure is described herein using a limited number of embodiments, these specific embodiments are for illustrative purposes and are not intended to limit the scope of the disclosure as otherwise described and claimed herein. Modification and variations from the described embodiments exist. The scope of the invention is defined by the appended claims.

Preferred Embodiments of the Present Invention are as numbered below:
1. A metering system comprising:
   a meter socket; and
   a meter configured to couple to the meter socket, the meter comprising:
      a memory;
      a plurality of sensors, each of which is configured to detect a different condition of the meter; and
      a processor configured to:
         determine a plurality of events that have occurred based on the conditions detected by the sensors;
         compare the plurality of events to a table stored in the memory of the meter, the table defining an action to be performed by the meter for each of a plurality of different combinations of the plurality of events;
         select an action from the table for which the plurality of events match a corresponding combination of events stored in the table; and perform the selected action.
2. The system of 1, wherein the actions defined in the table stored in memory include at least one of (i) log the plurality of events in the memory, (ii) send an alarm to a head-end system, (iii) take a billing data snapshot, (iv) record billing data in an alternate register, (v) disable an optional communications module, and (vi) open a disconnect switch.
3. The system of 1, wherein the meter further comprises a meter cover configured to couple to the meter, and wherein the plurality of sensors includes a cover removal sensor that senses whether the meter cover is coupled to the meter and provides a cover signal indicative of whether the meter cover is coupled to the meter, and wherein the processor is further configured to receive the cover signal and determine a condition of the meter cover.
4. The system of 3, wherein the meter is further configured for metering electrical energy delivered from a voltage source to an electrical load, and wherein the plurality of sensors includes a voltage sensor that senses a voltage at the electrical load and provides a voltage signal indicative of a voltage at the electrical load, and wherein the processor is further configured to receive the voltage signal and determine a condition of the meter at the electrical load.
5. The system of 4, wherein the meter further comprises a disconnect switch for switching between an open position in which electrical energy is not supplied to the electrical load and a closed position in which electrical energy is supplied to the electrical load, and wherein at least one of the actions defined in the table stored in memory include controlling the disconnect switch to the open position.
6. The system of 1, further comprising an information storage device coupled to the meter socket, the information storage device comprising identification information stored therein, and wherein the plurality of sensors includes an identification sensor that reads the identification information from the information storage device and provides an identification signal indicative of the identification information, and wherein the processor is further configured to receive the identification signal and determine a condition of the meter identify.
7. The system of 6, wherein the information storage device is an NFC tag or an RFID tag.
8. The system of 6, wherein the identification information of the information storage device represents a geographic location of the meter socket.
9. The system of 1, wherein the plurality of sensors include a motion sensor that senses a movement of the meter and provides a movement signal indicative of the movement of the meter, wherein the processor is further configured to receive the movement signal and determine a condition of the movement of the meter.
10. The system of 1, wherein the plurality of sensors are further configured to sense and provide a signal indicative of at least one of (i) a magnetic field, (ii) a power interruption, (iii) a reverse energy, (iv) an excessive number of security access failures, and (v) a current transformer saturation.
11. In a metering system having a meter socket and a meter, a method for controlling the meter comprising:
   detecting a plurality of different conditions of the meter;
   determining a plurality of events that have occurred based on the detected plurality of different conditions;
   comparing the plurality of events to a table stored in a memory of the meter, the table defining an action to be performed by the meter for each of different combinations of the plurality of events;
   selecting an action from the table for which the plurality of events match a corresponding combination of events stored in the table; and
   performing the selected action.
12. The method of 11, wherein the actions include at least one of (i) logging the plurality of events in the memory, (ii) sending an alarm to a head-end system, (iii) taking a billing snapshot, (iv) recording billing data in an alternate register, and (v) disabling an optional communications module.
13. The method of 11, wherein the metering system further includes a meter cover configured to couple to the meter, the method further comprising:
   sensing whether the meter cover is coupled to the meter; and
   determining a condition of the meter based on whether the meter cover is coupled to the meter.
14. The method of 11, wherein the meter is configured to meter electrical energy delivered from a voltage source to an electrical load, the method further comprising:
   sensing a voltage at the electrical load; and
   determining a condition at the electrical load.
15. The method of 14, wherein the meter includes a disconnect switch for switching between an open position in which electrical energy is not supplied to the electrical load and a closed position in which electrical energy is supplied to the electrical load, and wherein at least one of the actions defined in the table stored in memory include controlling the disconnect switch to the open position.
16. The method of 11, wherein the meter includes an information storage device coupled to the meter socket, the information storage device including identification information stored therein, the method further comprising:
   reading the identification information from the information storage device; and
   determining a condition of the meter based on the identification information stored on the information storage device.
17. The method of 11, further comprising:
   sensing a movement of the meter relative to the meter socket; and
   determining a condition of the meter based on the movement of the meter.
18. A meter comprising:
   a memory;
   a plurality of sensors, each of which is configured to detect a different condition of the meter; and
   a processor configured to:
      determine a plurality of events that have occurred based on the conditions detected by the sensors;
      compare the plurality of events to a table stored in the memory of the meter, the table defining an action to be performed by the meter for each of a plurality of different combinations of the plurality of events;
      select an action from the table for which the plurality of events match a corresponding combination of events stored in the table; and
      perform the selected action.
19. The meter of 18, further comprising:
   a meter cover configured to couple to the meter, and wherein the plurality of sensors includes a cover removal sensor that senses whether the meter cover is coupled to the meter and provides a cover signal indicative of whether the meter cover is coupled to the meter, and wherein the processor is further configured to receive the cover signal and determine a condition of the meter cover.
20. The meter of 18, wherein the actions defined in the table stored in memory include at least one of (i) log the plurality of events in the memory, (ii) send an alarm to a head-end system, (iii) take a billing data snapshot, (iv) record billing data in an alternate register, and (v) disable an optional communications module.

## Claims

1. A metering system comprising:
a meter socket; and
a meter configured to couple to the meter socket, the meter comprising:
a memory;
a plurality of sensors, each of which is configured to detect a different condition of the meter; and
a processor configured to:
determine a plurality of events that have occurred based on the conditions detected by the sensors;
compare the plurality of events to a table stored in the memory of the meter, the table defining an action to be performed by the meter for each of a plurality of different combinations of the plurality of events;
select an action from the table for which the plurality of events match a corresponding combination of events stored in the table; and perform the selected action.

2. The system of claim 1, wherein the actions defined in the table stored in memory include at least one of (i) log the plurality of events in the memory, (ii) send an alarm to a head-end system, (iii) take a billing data snapshot, (iv) record billing data in an alternate register, (v) disable an optional communications module, and (vi) open a disconnect switch.

3. The system of claim 1, wherein the meter further comprises a meter cover configured to couple to the meter, and wherein the plurality of sensors includes a cover removal sensor that senses whether the meter cover is coupled to the meter and provides a cover signal indicative of whether the meter cover is coupled to the meter, and wherein the processor is further configured to receive the cover signal and determine a condition of the meter cover.

4. The system of claim 3, wherein the meter is further configured for metering electrical energy delivered from a voltage source to an electrical load, and wherein the plurality of sensors includes a voltage sensor that senses a voltage at the electrical load and provides a voltage signal indicative of a voltage at the electrical load, and wherein the processor is further configured to receive the voltage signal and determine a condition of the meter at the electrical load.

5. The system of claim 1, further comprising an information storage device coupled to the meter socket, the information storage device comprising identification information stored therein, and wherein the plurality of sensors includes an identification sensor that reads the identification information from the information storage device and provides an identification signal indicative of the identification information, and wherein the processor is further configured to receive the identification signal and determine a condition of the meter identify.

6. The system of claim 5, wherein the information storage device is an NFC tag or an RFID tag.

7. The system of claim 5, wherein the identification information of the information storage device represents a geographic location of the meter socket.

8. The system of claim 1, wherein the plurality of sensors include a motion sensor that senses a movement of the meter and provides a movement signal indicative of the movement of the meter, wherein the processor is further configured to receive the movement signal and determine a condition of the movement of the meter.

9. The system of claim 1, wherein the plurality of sensors are further configured to sense and provide a signal indicative of at least one of (i) a magnetic field, (ii) a power interruption, (iii) a reverse energy, (iv) an excessive number of security access failures, and (v) a current transformer saturation.

10. In a metering system having a meter socket and a meter, a method for controlling the meter comprising:
detecting a plurality of different conditions of the meter;
determining a plurality of events that have occurred based on the detected plurality of different conditions;
comparing the plurality of events to a table stored in a memory of the meter, the table defining an action to be performed by the meter for each of different combinations of the plurality of events;
selecting an action from the table for which the plurality of events match a corresponding combination of events stored in the table; and
performing the selected action.

11. The method of claim 10, wherein the metering system further includes a meter cover configured to couple to the meter, the method further comprising:
sensing whether the meter cover is coupled to the meter; and
determining a condition of the meter based on whether the meter cover is coupled to the meter.

12. The method of claim 10, wherein the meter is configured to meter electrical energy delivered from a voltage source to an electrical load, the method further comprising:
sensing a voltage at the electrical load; and
determining a condition at the electrical load.

13. The method of claim 10, wherein the meter includes an information storage device coupled to the meter socket, the information storage device including identification information stored therein, the method further comprising:
reading the identification information from the information storage device; and
determining a condition of the meter based on the identification information stored on the information storage device.

14. The method of claim 10, further comprising:
sensing a movement of the meter relative to the meter socket; and
determining a condition of the meter based on the movement of the meter.

15. A meter comprising:
a memory;
a plurality of sensors, each of which is configured to detect a different condition of the meter; and
a processor configured to:
determine a plurality of events that have occurred based on the conditions detected by the sensors;
compare the plurality of events to a table stored in the memory of the meter, the table defining an action to be performed by the meter for each of a plurality of different combinations of the plurality of events;
select an action from the table for which the plurality of events match a corresponding combination of events stored in the table; and
perform the selected action.
